# EUROPEAN PATENT SPECIFICATION

(11) **EP 4 293 366 B1**
(45) Date of publication and mention of the grant of the patent: **11.03.2026**
(21) Application number: 23178686.4
(22) Date of filing: 12.06.2023
(51) Int. Cl.: G01R 19/255, G01R 35/00, H03M 1/06, H03M 1/60

(54) **SIGNAL PROCESSING CIRCUIT, CONTROLLER, ENVIRONMENT FORMING DEVICE, AND SIGNAL PROCESSING METHOD**
SIGNALVERARBEITUNGSSCHALTUNG, STEUERUNG, UMGEBUNGSERZEUGUNGSVORRICHTUNG UND SIGNALVERARBEITUNGSVERFAHREN
CIRCUIT DE TRAITEMENT DE SIGNAL, CONTRÔLEUR, DISPOSITIF DE FORMATION D'ENVIRONNEMENT ET PROCÉDÉ DE TRAITEMENT DE SIGNAL

(30) Priority: 14.06.2022 JP 2022095773
(43) Date of publication of application: 20.12.2023
(73) Proprietor: Espec Corp., Kita-ku Osaka-shi Osaka 530-8550 (JP)
(72) Inventor: MAKINO, Toshiaki, Japan, 530-8550 (JP)
(74) Representative: SSM Sandmair

(56) References cited:
- EP-B1- 2 223 049
- JP-B2- 5 253 110
- US-A1- 2020 028 219
- US-A1- 2021 083 682
- US-A1- 2022 057 452

## Description

### FIELD OF INVENTION

The present invention relates to a signal processing circuit, a controller, an environment forming device, and a signal processing method.

### BACKGROUND ART

A voltage measuring device according to related art is disclosed in, for example, JP S57-108759 A. In the voltage measuring device, a measured voltage is amplified by an amplifier circuit, is converted into digital data by an AD conversion circuit, and then is inputted to a microprocessor.

The voltage measuring device according to related art does not have a function of detecting a drop in the conversion precision by a voltage measuring circuit, such as an AD conversion circuit, the drop being caused by time-dependent deterioration or the like. It is therefore necessary to periodically perform a precision inspection of the voltage measuring device, using a high-precision reference device or the like with calibration traceability, and such inspection work is cumbersome.
EP 2 223 049 B1 discloses a method for accurately acquiring multiple analog input signals that are converted using a plurality of A/D converters into corresponding digital single measured values. US 2022/057452 A1 relates to an intelligent battery sensing system with a voltage measurement channel and a current measurement channel.
US 2021/083682 A1 relates to an analog input device which converts an inputted analog signal to a digital signal and outputs the converted digital signal.
US 2020/028219 A1 discloses a fault-tolerant battery sensing system that acquires battery information of a battery string comprised of multiple battery cells connected in series.

### SUMMARY OF THE INVENTION

An object of the present invention is to provide a signal processing circuit, a controller, an environment forming device, and a signal processing method that can easily detect a drop in the conversion precision from a voltage measurement value to voltage data, the drop being caused by time-dependent deterioration or the like.

A signal processing circuit according to a first aspect of the present invention is defined in independent claim 1. A further signal processing circuit according to a second aspect of the present invention is defined in independent claim 2.

According to the invention, the signal processing unit detects an error in the case where the second correspondence relationship is different from the first correspondence relationship representing the reference correspondence relationship, the second correspondence relationship representing the correspondence relationship between the voltage value indicated by the voltage data coming in from the first conversion unit and the frequency value indicated by the frequency data coming in from the second conversion unit. Hence a drop in the conversion precision of the first conversion unit, the drop being caused by time-dependent deterioration or the like, can be detected easily.

According to the first aspect, the signal processing unit generates the reference clock, based on the time-sequence data at the current time acquired from outside, and, by using the reference clock, can calculate more accurately the frequency value indicated by the frequency data coming in from the second conversion unit.

A signal processing circuit according to a third aspect of the present invention is provided as the signal processing circuit of the first or second aspect in which the signal processing unit corrects the voltage value indicated by the voltage data, based on the amount of a difference between the first correspondence relationship and the second correspondence relationship.

According to the third aspect, the signal processing unit can easily correct the voltage value indicated by the voltage data, based on the amount of the difference between the first correspondence relationship and the second correspondence relationship.

A controller according to a fourth aspect of the present invention includes the signal processing circuit according to any one of the first aspect to the third aspect.

According to the fourth aspect, the controller can easily detect a drop in the conversion precision of the first conversion unit, the drop being caused by time-dependent deterioration or the like.

An environment forming device according to a fifth aspect of the present invention includes the controller according to the fourth aspect.

According to the fifth aspect, the environment forming device can easily detect a drop in the conversion precision of the first conversion unit, the drop being caused by time-dependent deterioration or the like.

A signal processing method according to a sixth aspect of the present invention is defined in independent claim 6 and a further signal processing method according to a seventh aspect of the present invention is defined in independent claim 7.

According to the sixth and seventh aspect, the signal processing circuit detects an error in the case where the second correspondence relationship is different from the first correspondence relationship representing the reference correspondence relationship, the second correspondence relationship representing the correspondence relationship between the voltage value indicated by the voltage data and the frequency value indicated by the frequency data. Hence a drop in the conversion precision from a voltage measurement value into voltage data, the drop being caused by time-dependent deterioration or the like, can be detected easily.

### BRIEF DESCRIPTION OF THE DRAWINGS

Fig. 1 depicts a simplified overall configuration of an environment testing device according to a first embodiment;
Fig. 2 depicts a simplified configuration of a signal processing circuit according to the first embodiment; and
Fig. 3 depicts a simplified configuration of a signal processing circuit according to a second embodiment.

### DETAILED DESCRIPTION

Embodiments of the present invention will hereinafter be described with reference to the drawings. Constituent elements denoted by the same reference numerals in different drawings represent the same or corresponding constitutional elements.

### <First Embodiment>

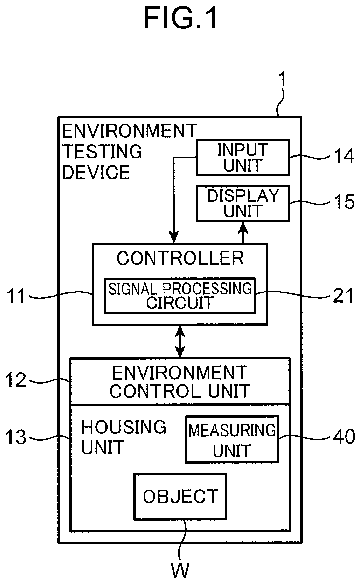

Fig. 1 depicts a simplified overall configuration of an environment testing device 1 according to a first embodiment of the present invention. The environment testing device 1 includes a controller 11, an environment control unit 12, a housing unit 13, an input unit 14, and a display unit 15.

The controller 11 includes a signal processing circuit 21. The signal processing circuit 21 is constituted of a microprocessor or the like.

The environment control unit 12 is constituted of a heating device, a cooling device, a humidifying device, a dehumidifying device, and the like. The environment control unit 12 operates under control by the controller 11, controlling the temperature or the temperature and humidity of the internal environment of the housing unit 13. The above configuration of the environment control unit 12 is an example, and may be changed, depending on the subject of control over internal environment conditions of the housing unit 13. For example, when only the temperature of the internal environment is controlled, the environment control unit 12 may be constituted of the heating device only. The environment control unit 12 may be a unit that controls the pressure of the internal environment of the housing unit 13. In this case, the environment control unit 12 may be constituted of a decompressor and/or a pressurizer.

The housing unit 13 is a chamber encircled with a heat-insulating casing, and has an object W housed in the housing unit 13. The object W is, for example, an electronic component, such as a circuit board.

A measuring unit 40 is disposed inside the housing unit 13. The measuring unit 40 is constituted of a temperature sensor, a humidity sensor, or a pressure sensor. The temperature sensor is constituted of a thermocouple, a temperature-measuring resistor, or the like, and measures the temperature of the internal environment of the housing unit 13. The measuring unit 40 may further include a temperature sensor (not illustrated) that measures the temperature of a refrigeration circuit making up a refrigeration device and/or a dehumidifying device of the environment control unit 12. The humidity sensor is, for example, a resistance type humidity sensor, and measures the humidity of the internal environment of the housing unit 13. The pressure sensor is constituted of a pressure-sensitive element or the like. When the housing unit 13 is a vacuum chamber or the like, the pressure sensor measures the internal pressure of the chamber. The pressure sensor may be a sensor (not illustrated) that measures a security pressure of the refrigeration circuit making up the refrigeration device and/or the dehumidifying device of the environment control unit 12. The measuring unit 40 outputs a voltage value corresponding to a measurement object or outputs a current value or a resistance value corresponding to the measurement object. When the measuring unit 40 outputs a current value or a resistance value, the outputted current value or resistance value is converted into a voltage value by a current-voltage conversion circuit or a resistance-voltage conversion circuit (not illustrated).

The input unit 14 is constituted of an operation switch, a touch panel, or the like. The display unit 15 is constituted of, for example, a liquid crystal display, an organic EL display, or the like. The input unit 14 and the display unit 15 may be integrated together in the form of, for example, a touch panel display.

The environment testing device 1 is an example of an environment forming device. The environment testing device 1 applies a temperature stress or both a temperature stress and a humidity stress to the object W, thereby evaluating the performance, etc. of the object W. However, the environment forming device may be a heat treatment device or the like that performs heat treatment, such as heating, on the object W, or may be a vacuum heating device or the like that performs pressure treatment, such as depressurizing, on the object W.

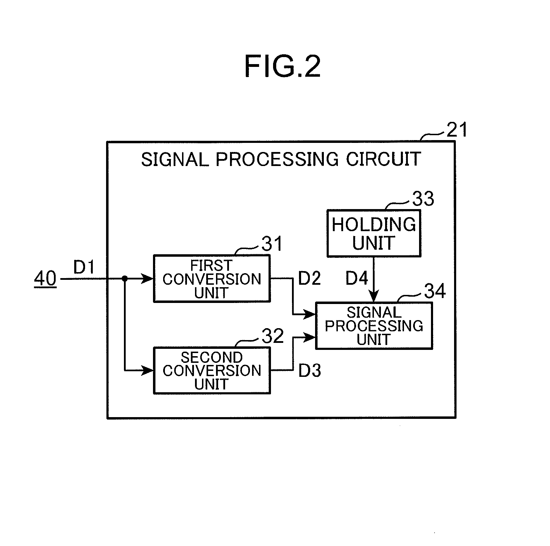

Fig. 2 depicts a simplified configuration of the signal processing circuit 21 according to the first embodiment. The signal processing circuit 21 includes a first conversion unit 31, a second conversion unit 32, a holding unit 33, and a signal processing unit 34. The signal processing circuit 21 may include a signal amplifying unit (not illustrated) or the like constituted of an amplifying circuit that is disposed at a preceding stage to the first conversion unit 31 and the second conversion unit 32.

The first conversion unit 31 is constituted of an analog-to-digital converter (ADC). The first conversion unit 31 converts a voltage measurement value D1 in the form of an analog signal coming in from the measuring unit 40, into voltage data D2 in the form of a digital signal and outputs the voltage data D2. The voltage data D2 outputted from the first conversion unit 31 is inputted to the signal processing unit 34. The voltage measurement value D1 may be a voltage value outputted from the measuring unit 40 or a voltage value to which a current value or a resistance value from the measuring unit 40 is converted.

The second conversion unit 32 is constituted of a voltage-to-frequency converter (VFC). The second conversion unit 32 converts the voltage measurement value D1 in the form of an analog signal coming in from the measuring unit 40, into frequency data D3 in the form of a digital signal pulse train and outputs the frequency data D3. For example, the smaller the voltage measurement value D1, the lower the frequency of the pulse train, and the larger the voltage measurement value D1, the higher the frequency of the pulse train. The frequency data D3 outputted from the second conversion unit 32 is inputted to the signal processing unit 34.

The holding unit 33 is constituted of a nonvolatile semiconductor memory or the like. The holding unit 33 holds a first correspondence relationship representing a reference correspondence relationship between a voltage value indicated by the voltage data D2 and a frequency value indicated by the frequency data D3. The first correspondence relationship is table information, function information, or the like indicating a correspondence relationship between a plurality of voltage values and a plurality of frequency values. The first correspondence relationship may be created in advance, using a high-precision voltage generator with calibration traceability, before a time-dependent deterioration occurs at the ADC or the like included in the first conversion unit 31 and the VFC included in the second conversion unit 32, or may be created in advance, using product specification information on the ADC and the VFC. Data D4 indicating the first correspondence relationship is inputted from the holding unit 33 to the signal processing unit 34.

The signal processing unit 34 is constituted of a processor, such as a CPU. In a period of execution of an environmental test by the environment testing device 1, the signal processing unit 34 creates a second correspondence relationship representing a correspondence relationship between a voltage value indicated by the voltage data D2 coming in from the first conversion unit 31 and a frequency value indicated by the frequency data D3 coming in from the second conversion unit 32. The signal processing unit 34 compares the created second correspondence relationship with the first correspondence relationship indicated by the data D4 coming in from the holding unit 33. When the comparison results indicate that the second correspondence relationship is identical with the first correspondence relationship, the signal processing unit 34 determines that the first conversion unit 31 is in a normal state. When the comparison results indicate that the second correspondence relationship is different from the first correspondence relationship, the signal processing unit 34 determines that the first conversion unit 31 is in an abnormal state, that is, detects an error. The signal processing unit 34 may set an error allowable range in advance for the first correspondence relationship and when a difference between the second correspondence relationship and the first correspondence relationship exceeds the set error allowable range, may determine that the first conversion unit 31 is in the abnormal state. This process avoids a case where an abnormality determination is made frequently due to minute noise or the like.

When detecting an error, the signal processing unit 34 displays a warning, such as a text message or a graphic representation for noticing of the occurrence of an error, on the display unit 15. The warning may include information indicating the amount of the difference between the first correspondence relationship and the second correspondence relationship. By displaying the warning on the display unit 15, the operator is able to determine whether to continue the environmental test or to do it over again. The form of the error notice is not limited to a notice displayed on the display unit 15 and may also be a warning announcement or warning sound outputted from a speaker (not illustrated).

When detecting an error, the signal processing unit 34 may record flag information indicative of being in an error detection period, together with time information and the like, in the holding unit 33. As a result, the error detection period in the period of execution of the environmental test by the environment testing device 1 can be specified later, and therefore information on the error detection period can be utilized for a defective lot analysis and the like.

According to the signal processing circuit 21 of the first embodiment, the signal processing unit 34 detects an error in a case where the second correspondence relationship representing the correspondence relationship between the voltage value indicated by the voltage data D2 coming in from the first conversion unit 31 and the frequency value indicated by the frequency data D3 coming in from the second conversion unit 32 is different from the first correspondence relationship representing the reference correspondence relationship. Hence a drop in the conversion precision of the first conversion unit 31, the drop being caused by time-dependent deterioration, etc., can be detected easily.

### <Second Embodiment>

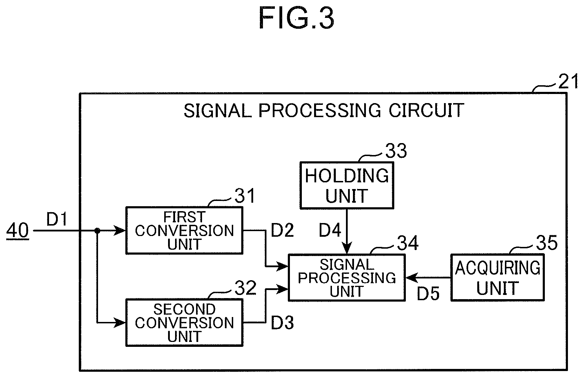

Fig. 3 depicts a simplified configuration of a signal processing circuit 21 according to a second embodiment. The signal processing circuit 21 includes the first conversion unit 31, the second conversion unit 32, the holding unit 33, the signal processing unit 34, and an acquiring unit 35.

The acquiring unit 35 is constituted of a standard radio wave receiver of an atomic clock, a GPS signal receiver, or the like. The standard radio wave or the GPS signal includes current time information. The acquiring unit 35 keeps receiving the standard radio wave or the GPS signal, thereby acquiring time-sequence data D5 at the current time from outside. The time-sequence data D5 is inputted from the acquiring unit 35 to the signal processing unit 34.

Based on the time-sequence data D5 coming in from the acquiring unit 35, the signal processing unit 34 generates a reference clock with a given frequency. The given frequency is, for example, 1 Hz. This 1 Hz reference clock is not one with calibration traceability, but can be regarded as extremely accurate reference information.

The signal processing unit 34 calculates a frequency value indicated by the frequency data D3, based on a pulse train of the generated 1 Hz reference clock and on a pulse train of the frequency data D3 coming in from the second conversion unit 32. For example, the signal processing unit 34 calculates the frequency value indicated by the frequency data D3, as the reciprocal of a ratio of the period of the pulse train of the frequency data D3 to the period of the pulse train of the 1 Hz reference clock.

In the period of execution of the environmental test by the environment testing device 1, the signal processing unit 34 creates a second correspondence relationship representing a correspondence relationship between a voltage value indicated by the voltage data D2 coming in from the first conversion unit 31 and a frequency value calculated based on the reference clock and on the frequency data D3 coming in from the second conversion unit 32. The signal processing unit 34 compares the created second correspondence relationship with the first correspondence relationship indicated by the data D4 coming in from the holding unit 33. When the comparison results indicate that the second correspondence relationship is identical with the first correspondence relationship, the signal processing unit 34 determines that the first conversion unit 31 is in a normal state. When the comparison results indicate that the second correspondence relationship is different from the first correspondence relationship, the signal processing unit 34 determines that the first conversion unit 31 is in an abnormal state, that is, detects an error. The signal processing unit 34 may set an error allowable range in advance for the first correspondence relationship and when a difference between the second correspondence relationship and the first correspondence relationship exceeds the set error allowable range, may determine that the first conversion unit 31 is in the abnormal state. This process avoids a case where an abnormality determination is made frequently due to minute noise or the like.

When detecting an error, the signal processing unit 34 displays a warning, such as a text message or a graphic representation for noticing of the occurrence of an error, on the display unit 15. The warning may include information indicating the amount of the difference between the first correspondence relationship and the second correspondence relationship. By displaying the warning on the display unit 15, the operator is able to determine whether to continue the environmental test or to do it over again. The form of the error notice is not limited to a notice displayed on the display unit 15 and may also be a warning announcement or warning sound outputted from a speaker (not illustrated). This warning may include a message asking whether or not to execute a difference correction process. When an answer indicating execution of the difference correction process is inputted to the input unit 14, the signal processing unit 34 executes a correction process of adding or subtracting a voltage value equivalent to the amount of the difference between the first correspondence relationship and the second correspondence relationship, to or from the voltage value indicated by the voltage data D2 coming in from the first conversion unit 31. Timing of execution of the difference correction process may be determined by the operator's input to the input unit 14, by which the operator chooses to execute the difference correction process during the period of execution of the environmental test by the environment testing device 1 or to execute the same after completion of the period of execution of the environmental test by the environment testing device 1. Executing the correction process during the period of execution of the environmental test allows the difference to be eliminated quickly. Executing the correction process after completion of the period of execution of the environmental test, on the other hand, avoids a case where an output value from the first conversion unit 31 is changed stepwise during execution of the environmental test. The signal processing unit 34 may automatically execute the difference correction process, in which case the warning message does not include the message asking whether or not to execute the difference correction process. The difference correction process by the signal processing unit 34 is not limited to be executed in the second embodiment but may be executed in the first embodiment.

When detecting an error, the signal processing unit 34 may record flag information indicative of being in an error detection period, together with time information and the like, in the holding unit 33. As a result, the error detection period in the period of execution of the environmental test by the environment testing device 1 can be specified later, and therefore information on the error detection period can be utilized for a defective lot analysis and the like. The flag information may include information indicating the amount of the difference between the first correspondence relationship and the second correspondence relationship. As a result, the amount of the difference can be accurately corrected later. The process of recording the flag information by the signal processing unit 34 is not limited to be executed in the second embodiment but may be executed in the first embodiment.

According to the signal processing circuit 21 of the second embodiment, the signal processing unit 34 generates the reference clock, based on the time-sequence data D5 at the current time acquired from outside, and, by using the reference clock, can accurately calculate the frequency value indicated by the frequency data D3 coming in from the second conversion unit 32.

According to the signal processing circuit 21 of the second embodiment, the signal processing unit 34 can easily correct the voltage value indicated by the voltage data D2, based on the amount of the difference between the first correspondence relationship and the second correspondence relationship.

## Claims

1. A signal processing circuit (21) comprising:
a first conversion unit (31) that converts a voltage measurement value coming in from a measuring unit (40), into voltage data and outputs the voltage data; and
a second conversion unit (32) that converts the voltage measurement value coming in from the measuring unit (40), into frequency data and outputs the frequency data, **characterised in that**
the signal processing circuit (21) further comprises:
a holding unit (33) that holds a first correspondence relationship representing a reference correspondence relationship between a voltage value indicated by the voltage data and a frequency value indicated by the frequency data;
a signal processing unit (34) that detects an error in a case where a second correspondence relationship is different from the first correspondence relationship, the second correspondence relationship representing a correspondence relationship between a voltage value indicated by the voltage data coming in from the first conversion unit (31) and a frequency value indicated by the frequency data coming in from the second conversion unit (32); and
an acquiring unit (35) that acquires time-sequence data at a current time based on a standard radio wave or a GPS signal received from outside the signal processing circuit (21), wherein
the signal processing unit (34) generates a reference clock with a given frequency, based on the time-sequence data coming in from the acquiring unit (35), and calculates the frequency value indicated by the frequency data, based on the reference clock and on the frequency data coming in from the second conversion unit (32).

2. A signal processing circuit (21) comprising:
a first conversion unit (31) that converts a voltage measurement value coming in from a measuring unit (40), into voltage data and outputs the voltage data; and
a second conversion unit (32) that converts the voltage measurement value coming in from the measuring unit (40), into frequency data and outputs the frequency data, **characterised in that**
the signal processing circuit (21) further comprises:
a holding unit (33) that holds a first correspondence relationship created in advance, which is table information or function information indicating a correspondence relationship between a plurality of voltage values and a plurality of frequency values; and
a signal processing unit (34) that detects an error in a case where a second correspondence relationship is different from the first correspondence relationship, the second correspondence relationship representing a correspondence relationship between a voltage value indicated by the voltage data coming in from the first conversion unit (31) and a frequency value indicated by the frequency data coming in from the second conversion unit (32).

3. The signal processing circuit (21) according to claim 1 or 2, wherein the signal processing unit (34) corrects the voltage value indicated by the voltage data, based on an amount of a difference between the first correspondence relationship and the second correspondence relationship.

4. A controller (11) comprising the signal processing circuit (21) according to any one of claims 1 to 3.

5. An environment forming device (1) comprising the controller (11) according to claim 4.

6. A signal processing method causing a signal processing circuit (21) to execute the processes of:
converting a voltage measurement value coming in from a measuring unit (40), into voltage data; and
converting the voltage measurement value coming in from the measuring unit (40), into frequency data, **characterised in that**
the signal processing method further causes the signal processing circuit (21) to execute the processes of: holding a first correspondence relationship representing a reference correspondence relationship between a voltage value indicated by the voltage data and a frequency value indicated by the frequency data;
detecting an error in a case where a second correspondence relationship is different from the first correspondence relationship, the second correspondence relationship representing a correspondence relationship between a voltage value indicated by the voltage data and a frequency value indicated by the frequency data;
acquiring time-sequence data at a current time based on a standard radio wave or a GPS signal received from outside the signal processing circuit (21);
generating a reference clock with a given frequency, based on the time-sequence data; and
calculating the frequency value indicated by the frequency data, based on the reference clock and on the frequency data.

7. A signal processing method causing a signal processing circuit (21) to execute the processes of:
converting a voltage measurement value coming in from a measuring unit (40), into voltage data; and
converting the voltage measurement value coming in from the measuring unit (40), into frequency data, **characterised in that**
the signal processing method further causes the signal processing circuit (21) to execute the processes of:
holding a first correspondence relationship created in advance, which is table information or function information indicating a correspondence relationship between a plurality of voltage values and a plurality of frequency values; and
detecting an error in a case where a second correspondence relationship is different from the first correspondence relationship, the second correspondence relationship representing a correspondence relationship between a voltage value indicated by the voltage data and a frequency value indicated by the frequency data.

## Patentansprüche

1. Signalverarbeitungsschaltung (21), die umfasst:
eine erste Umwandlungseinheit (31), die einen von einer Messeinheit (40) eingehenden Spannungsmesswert in Spannungsdaten umwandelt und die Spannungsdaten ausgibt; und
eine zweite Umwandlungseinheit (32), die den von der Messeinheit (40) kommenden Spannungsmesswert in Frequenzdaten umwandelt und die Frequenzdaten ausgibt,
**dadurch gekennzeichnet, dass**
die Signalverarbeitungsschaltung (21) ferner umfasst:
eine Speichereinheit (33), die eine erste Korrespondenzbeziehung speichert, welche eine Referenzkorrespondenzbeziehung zwischen einem durch die Spannungsdaten angegebenen Spannungswert und einem durch die Frequenzdaten angegebenen Frequenzwert darstellt;
eine Signalverarbeitungseinheit (34), die einen Fehler erkennt, wenn eine zweite Korrespondenzbeziehung von der ersten Korrespondenzbeziehung abweicht, wobei die zweite Korrespondenzbeziehung eine Korrespondenzbeziehung zwischen einem Spannungswert darstellt, der durch die von der ersten Umwandlungseinheit (31) eingehenden Spannungsdaten angegeben wird, und einem Frequenzwert, der durch die von der zweiten Umwandlungseinheit (32) eingehenden Frequenzdaten angegeben wird; und
eine Erfassungseinheit (35), die Zeitsequenzdaten zum aktuellen Zeitpunkt auf der Grundlage einer Standardfunkwelle oder eines von außerhalb der Signalverarbeitungsschaltung (21) empfangenen GPS-Signals erfasst, wobei
die Signalverarbeitungseinheit (34) einen Referenztakt mit einer vorgegebenen Frequenz auf Basis der von der Erfassungseinheit (35) eingehenden Zeitsequenzdaten erzeugt und den durch die Frequenzdaten angegebenen Frequenzwert auf Basis des Referenztakts und der von der zweiten Konvertierungseinheit (32) eingehenden Frequenzdaten berechnet.

2. Signalverarbeitungsschaltung (21), die umfasst:
eine erste Umwandlungseinheit (31), die einen von einer Messeinheit (40) eingehenden Spannungsmesswert in Spannungsdaten umwandelt und die Spannungsdaten ausgibt; und
eine zweite Umwandlungseinheit (32), die den von der Messeinheit (40) kommenden Spannungsmesswert in Frequenzdaten umwandelt und die Frequenzdaten ausgibt.
**dadurch gekennzeichnet, dass**
die Signalverarbeitungsschaltung (21) ferner umfasst:
eine Speichereinheit (33), die eine zuvor erstellte erste Korrespondenzbeziehung enthält, die Tabelleninformationen oder Funktionsinformationen enthält, welche eine Korrespondenzbeziehung zwischen mehreren Spannungswerten und mehreren Frequenzwerten angeben; und
eine Signalverarbeitungseinheit (34), die einen Fehler erkennt, wenn eine zweite Korrespondenzbeziehung von der ersten Korrespondenzbeziehung abweicht, wobei die zweite Korrespondenzbeziehung eine Korrespondenzbeziehung zwischen einem Spannungswert darstellt, der durch die von der ersten Umwandlungseinheit (31) eingehenden Spannungsdaten angezeigt wird, und einem Frequenzwert, der durch die von der zweiten Umwandlungseinheit (32) eingehenden Frequenzdaten angezeigt wird.

3. Signalverarbeitungsschaltung (21) nach Anspruch 1 oder 2, wobei die Signalverarbeitungseinheit (34) den durch die Spannungsdaten angezeigten Spannungswert auf der Grundlage der Abweichung zwischen der ersten und der zweiten Korrespondenzbeziehung korrigiert.

4. Steuereinheit (11) mit der Signalverarbeitungsschaltung (21) nach einem der Ansprüche 1 bis 3.

5. Umgebungserzeugungsvorrichtung (1) mit der Steuereinheit (11) nach Anspruch 4.

6. Signalverarbeitungsverfahren, das eine Signalverarbeitungsschaltung (21) veranlasst, die folgenden Prozesse auszuführen:
Umwandlung eines von einer Messeinheit (40) eingehenden Spannungsmesswertes in Spannungsdaten; und
Umwandlung des von der Messeinheit (40) kommenden Spannungsmesswertes in Frequenzdaten,
**dadurch gekennzeichnet, dass**
das Signalverarbeitungsverfahren ferner bewirkt, dass die Signalverarbeitungsschaltung (21) die folgenden Vorgänge ausführt: Speichern einer ersten Korrespondenzbeziehung, die eine Referenzkorrespondenzbeziehung zwischen einem durch die Spannungsdaten angegebenen Spannungswert und einem durch die Frequenzdaten angegebenen Frequenzwert darstellt;
Erkennung eines Fehlers, wenn eine zweite Korrespondenzbeziehung von der ersten Korrespondenzbeziehung abweicht, wobei die zweite Korrespondenzbeziehung eine Korrespondenzbeziehung zwischen einem durch die Spannungsdaten angegebenen Spannungswert und einem durch die Frequenzdaten angegebenen Frequenzwert darstellt;
Erfassung von Zeitsequenzdaten zum aktuellen Zeitpunkt auf Basis einer StandardFunkwelle oder eines von außerhalb des Signalverarbeitungsschaltkreises empfangenen GPS-Signals (21);
Erzeugung eines Referenztakts mit einer vorgegebenen Frequenz auf Basis der Zeitsequenzdaten; und
Berechnung des Frequenzwerts, der durch die Frequenzdaten angezeigt wird, basierend auf dem Referenztakt und den Frequenzdaten.

7. Signalverarbeitungsverfahren, das einen Signalverarbeitungsschaltkreis (21) veranlasst, die folgenden Prozesse auszuführen:
Umwandlung eines von einer Messeinheit (40) eingehenden Spannungsmesswertes in Spannungsdaten; und
Umwandlung des von der Messeinheit (40) eingehenden Spannungsmesswertes in Frequenzdaten,
**dadurch gekennzeichnet, dass**
das Signalverarbeitungsverfahren ferner bewirkt, dass die Signalverarbeitungsschaltung (21) die folgenden Prozesse ausführt:
Speicherung einer im Voraus erstellten ersten Korrespondenzbeziehung, die Tabelleninformationen oder Funktionsinformationen enthält, welche eine Korrespondenzbeziehung zwischen mehreren Spannungswerten und mehreren Frequenzwerten angeben; und
Erkennung eines Fehlers in einem Fall, in dem eine zweite Korrespondenzbeziehung von der ersten Korrespondenzbeziehung abweicht, wobei die zweite Korrespondenzbeziehung eine Korrespondenzbeziehung zwischen einem durch die Spannungsdaten angegebenen Spannungswert und einem durch die Frequenzdaten angegebenen Frequenzwert darstellt.

## Revendications

1. Circuit de traitement de signal (21) comprenant :
une première unité de conversion (31) qui convertit une valeur de mesure de tension provenant d'une unité de mesure (40) en données de tension et émet les données de tension, et
une deuxième unité de conversion (32) qui convertit la valeur de mesure de tension provenant de l'unité de mesure (40) en données de fréquence et émet les données de fréquence ;
**caractérisé en ce que** le circuit de traitement de signal (21) comprend en outre :
une unité de retenue (33) qui retient une première relation de correspondance représentant une relation de correspondance de référence entre une valeur de tension indiquée par les données de tension et une valeur de fréquence indiquée par les données de fréquence,
une unité de traitement de signal (34) qui détecte une erreur si une deuxième relation de correspondance est différente de la première relation de correspondance, la deuxième relation de correspondance représentant une relation de correspondance entre une valeur de tension indiquée par les données de tension provenant de la première unité de conversion (31) et une valeur de fréquence indiquée par les données de fréquence provenant de la deuxième unité de conversion (32), et
une unité d'acquisition (35) qui acquiert des données chronologiques à un instant présent en fonction d'une onde radio standard ou d'un signal GPS reçu depuis l'extérieur du circuit de traitement de signal (21),
l'unité de traitement de signal (34) générant une horloge de référence avec une fréquence donnée, en fonction des données chronologiques provenant de l'unité d'acquisition (35), et calculant la valeur de fréquence indiquée par les données de fréquence, en fonction de l'horloge de référence et des données de fréquence provenant de la deuxième unité de conversion (32).

2. Circuit de traitement de signal (21) comprenant :
une première unité de conversion (31) qui convertit une valeur de mesure de tension provenant d'une unité de mesure (40) en données de tension et émet les données de tension, et
une deuxième unité de conversion (32) qui convertit la valeur de mesure de tension provenant de l'unité de mesure (40) en données de fréquence et émet les données de fréquence,
**caractérisé en ce que** le circuit de traitement de signal (21) comprend en outre :
une unité de retenue (33) qui retient une première relation de correspondance créée au préalable, consistant en des informations tabulaires ou des information de fonction indiquant une relation de correspondance entre une pluralité de valeurs de tension et une pluralité de valeurs de fréquence, et
une unité de traitement de signal (34) qui détecte une erreur si une deuxième relation de correspondance est différente de la première relation de correspondance, la deuxième relation de correspondance représentant une relation de correspondance entre une valeur de tension indiquée par les données de tension provenant de la première unité de conversion (31) et une valeur de fréquence indiquée par les données de fréquence provenant de la deuxième unité de conversion (32).

3. Circuit de traitement de signal (21) selon la revendication 1 ou 2, dans lequel l'unité de traitement de signal (34) corrige la valeur de tension indiquée par les données de tension, en fonction de la grandeur de différence entre la première relation de correspondance et la deuxième relation de correspondance.

4. Dispositif de commande (11) comprenant le circuit de traitement de signal (21) selon l'une quelconque des revendications 1 à 3.

5. Dispositif de formation d'environnement (1) comprenant le dispositif de commande (11) selon la revendication 4.

6. Procédé de traitement de signal amenant un circuit de traitement de signal (21) à exécuter les processus consistant à :
convertir une valeur de mesure de tension provenant d'une unité de mesure (40) en données de tension, et
convertir la valeur de mesure de tension provenant de l'unité de mesure (40) en données de fréquence ;
**caractérisé en ce que** le procédé de traitement de signal amène en outre le circuit de traitement de signal (21) à exécuter les processus consistant à :
retenir une première relation de correspondance représentant une relation de correspondance de référence entre une valeur de tension indiquée par les données de tension et une valeur de fréquence indiquée par les données de fréquence,
détecter une erreur si une deuxième relation de correspondance est différente de la première relation de correspondance, la deuxième relation de correspondance représentant une relation de correspondance entre une valeur de tension indiquée par les données de tension et une valeur de fréquence indiquée par les données de fréquence,
acquérir des données chronologiques à un instant présent en fonction d'une onde radio standard ou d'un signal GPS reçu depuis l'extérieur du circuit de traitement de signal (21),
générer une horloge de référence avec une fréquence donnée, en fonction des données chronologiques, et
calculer la valeur de fréquence indiquée par les données de fréquence, en fonction de l'horloge de référence et des données de fréquence.

7. Procédé de traitement de signal amenant un circuit de traitement de signal (21) à exécuter les processus consistant à :
convertir une valeur de mesure de tension provenant d'une unité de mesure (40) en données de tension, et
convertir la valeur de mesure de tension provenant de l'unité de mesure (40) en données de fréquence ;
**caractérisé en ce que** le procédé de traitement de signal amène en outre le circuit de traitement de signal (21) à exécuter les processus consistant à :
retenir une première relation de correspondance créée au préalable, consistant en des informations tabulaires ou des informations de fonction indiquant une relation de correspondance entre une pluralité de valeurs de tension et une pluralité de valeurs de fréquence, et
détecter une erreur si une deuxième relation de correspondance est différente de la première relation de correspondance, la deuxième relation de correspondance représentant une relation de correspondance entre une valeur de tension indiquée par les données de tension et une valeur de fréquence indiquée par les données de fréquence.
